# EUROPEAN PATENT SPECIFICATION

(11) **EP 2 491 168 B1**
(45) Date of publication and mention of the grant of the patent: **07.08.2013**
(21) Application number: 10787881.1
(22) Date of filing: 20.10.2010
(51) Int. Cl.: H05B 6/24, B22D 27/04, C30B 11/00, C30B 29/06, C30B 35/00, F27B 14/14, H05B 6/36, H05B 6/44

(54) **DEVICE FOR OBTAINING A MULTICRYSTALLINE SEMICONDUCTOR MATERIAL, IN PARTICULAR SILICON, AND METHOD FOR CONTROLLING THE TEMPERATURE THEREIN**
VERFAHREN ZUR GEWINNUNG EINES POLYKRISTALLINEN HALBLEITERMATERIALS, IM BESONDEREN SILIZIUM, UND VERFAHREN ZUR TEMPERATURREGELUNG DAFÜR
DISPOSITIF D'OBTENTION D'UN MATÉRIAU SEMICONDUCTEUR POLYCRISTALLIN, EN PARTICULIER DU SILICIUM, ET PROCÉDÉ DE RÉGULATION DE LA TEMPÉRATURE DANS CELUI-CI

(30) Priority: 21.10.2009 IT TO20090794
(43) Date of publication of application: 29.08.2012
(73) Proprietor: Saet S.p.A., 10040 Leini (IT)
(72) Inventor: DUGHIERO, Fabrizio, I-35028 Piove Di Sacco (IT); FORZAN, Michele, I-35142 Padova (IT); CISCATO, Dario, I-35010 Gazzo (IT); CESANO, Mariolino, I-13047 San Germano Vercellese (IT); CRIVELLO, Fabrizio, I-10010 San Martino Canavese (IT); BECHINI, Roberto, I-10080 San Benigno Canavese (IT)
(74) Representative: Plebani, Rinaldo
(86) International application number: PCT/IB2010/002686
(87) International publication number: WO 2011/048474

(56) References cited:
- WO-A1-98/05185
- FR-A1- 2 909 990

## Description

### TECHNICAL FIELD

The present invention relates to a device for obtaining a multicrystalline semiconductor material, in particular silicon, by melting of the semiconductor material and subsequent directional solidification thereof, as well as to a method for obtaining a better control of the temperature of the semiconductor material.

### BACKGROUND ART

The demand for semiconductor material, in particular silicon, with a high degree of purity, referred to as "solar purity", is increasingly higher, in so far as said material serves for the production of high-efficiency photovoltaic cells.

To obtain such a material refinements are first made by means of traditional metallurgical processes and, finally, an ingot is formed, from which the wafers necessary for production of the photovoltaic cells can then be sectioned. Said ingot is formed with a methodology known as "Directional Solidification System" (DSS), i.e., by melting the semiconductor material in a crucible, and then causing a directional solidification thereof, obtaining, at the end, multicrystalline silicon.

To obtain the directional solidification it is necessary to bring about said solidification in the crucible by maintaining a vertical thermal gradient in the ingot being formed so as to obtain a rate of cooling such as to obtain advance of the solidification front at a rate of 1-2 cm/h. An advantage of said technology is that the impurities present in the starting material remain preferentially in the molten material and consequently rise upwards together with the solidification front. Once the ingot is solidified, it is consequently sufficient to eliminate the top part of the ingot itself to obtain refined multicrystalline silicon at the desired degree of purity.

To obtain said result it is necessary to be able to exert a very precise control of the thermal flows. Furthermore, the step of melting of the solid semiconductor material to be refined requires long times and high levels of energy consumption.

### DISCLOSURE OF INVENTION

The aim of the present invention is to overcome the drawbacks of the known art by providing a device made of a semiconductor material, typically multicrystalline silicon with "solar" degree of purity, as well as a method for controlling the temperature thereof that will be simple and inexpensive to implement, will enable a reliable and effective control of the thermal flows, and will enable reduction of the overall dimensions and the levels of energy consumption of the necessary equipment.

Here and in what follows by "solar" degree of purity is meant the degree of purity necessary for producing high-efficiency photovoltaic cells.

The invention hence regards a device for melting and subsequent directional solidification of a semiconductor material, typically to obtain multicrystalline silicon with solar degree of purity, according to Claim 1, and to a method for carrying out control of the temperature in a process of refinement of a semiconductor material in which the semiconductor material is melted and is subsequently subjected to directional solidification, according to Claim 9.

In particular, the device of the invention comprises: at least one crucible for the semiconductor material, preferably made of quartz or ceramic material, removably housed in a cup-shaped graphite container; a possible openable and fluid-tight casing, housing inside it the graphite container; one or more top induction coils, the induction coil being set facing, with interposition of a graphite plate, a mouth of the graphite container; one or more lateral induction coils, arranged around a side wall of the graphite container; one or more bottom induction coils, set facing a bottom wall of the graphite container; a.c. electrical-supply means for supplying the induction coils separately and independently of one another; and cooling means for supplying a coolant within respective hollow turns of the induction coils.

According to one aspect of the invention, the bottom block of induction coils comprises a plurality of windings arranged alongside one another in one and the same plane of lie defined by an insulated supporting plate, and electrical switching means are prearranged between the windings of the bottom induction coil and the respective a.c. electrical-supply means for selectively connecting the windings to one another according to different configurations, which differ from one another as regards the direction of circulation of the electric current in the respective windings set alongside one another.

Consequently, according to the method of the invention, the melting step is performed by heating the semiconductor material contained in a crucible by means of graphite susceptors, each operatively associated to at least one respective induction coil and arranged so as to surround the crucible, and, in order to obtain the desired control of the temperature, the following steps are performed:
- setting under the crucible a susceptor, operatively associated to at least one bottom induction coil comprising a plurality of windings arranged alongside one another in one and the same plane of lie; and
- selectively connecting the windings to one another and to respective a.c. electrical-supply means for supply of the bottom induction coil according to different configurations that differ from one another as regards the direction of circulation of the electric currents in the respective windings set alongside one another.

In this way, it is possible to vary with extreme simplicity and in a way that can be implemented a number of times during one and the same process the heat that the bottom graphite susceptor supplies to the crucible, without substantially altering any other operating parameter of the device, and in particular of the induction coils.

Preferably, moreover, the bottom induction coil is mobile so that its distance from the susceptor associated thereto can be varied both during the step of melting and during the step of solidification. In particular, during the latter, the bottom induction coil is deactivated and brought into contact with the susceptor, continuing to supply in the turns thereof a coolant so as to remove the heat present in the susceptor directly.

### BRIEF DESCRIPTION OF THE DRAWINGS

Further characteristics and advantages of the invention will appear clearly from the ensuing description of a non-limiting example of embodiment thereof, illustrated purely by way of example with reference to the figures of the annexed drawings, wherein:

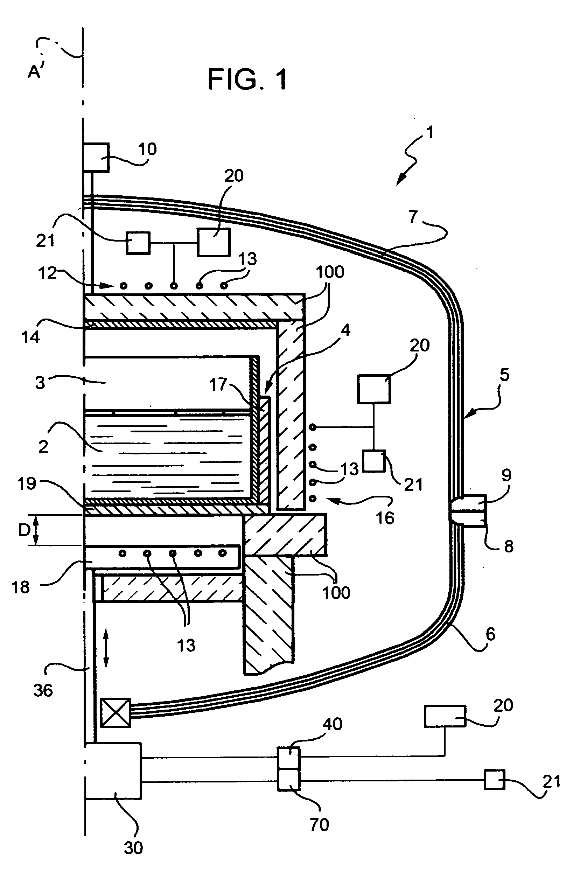

- Figure 1 illustrates a schematic view in elevation and sectioned parallel to the axis of vertical symmetry of a device for melting and subsequent directional solidification of a semiconductor material, made according to the invention and only half of which is illustrated, the part removed being symmetrical;

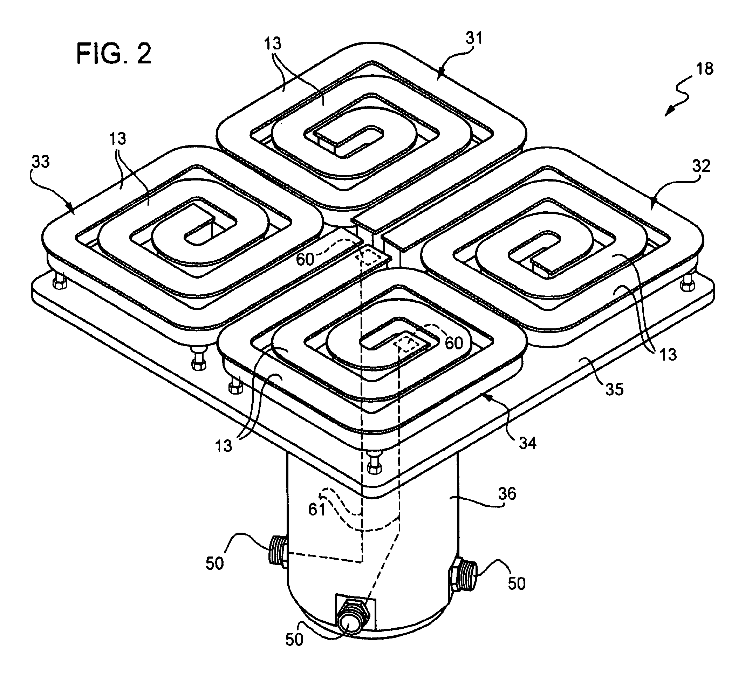

- Figure 2 illustrates at an enlarged scale a perspective view three quarters from above of a bottom induction coil of the device of Figure 1; and

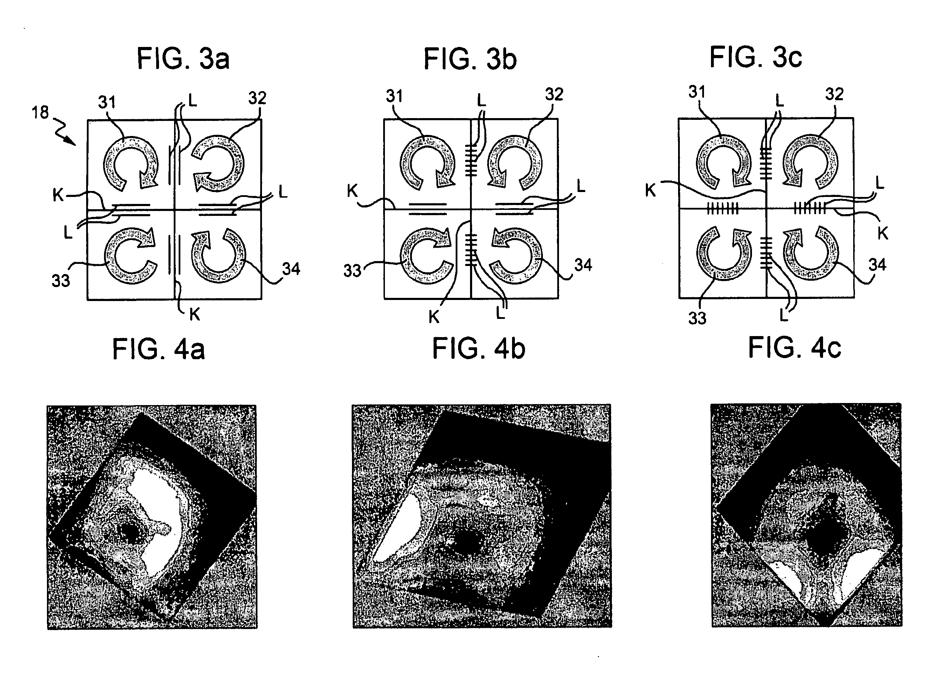

- Figures 3 and 4 are respective schematic illustrations of three different possible operating configurations of the induction coil of Figure 2 and the consequent distributions of temperature in a graphite plate set between the induction coil and a crucible containing the semiconductor material to be heated.

### BEST MODE FOR CARRYING OUT THE INVENTION

With reference to Figures 1 and 2, designated as a whole by 1 is a device for melting and subsequent directional solidification of a semiconductor material 2, typically to obtain multicrystalline silicon with "solar" degree of purity.

The device 1 comprises: at least one crucible 3 for the semiconductor material 2, preferably made of quartz or ceramic material, removably housed in a cup-shaped graphite container 4; and a fluid-tight casing 5, housing inside it the graphite container 4 and delimited by a bottom half-shell 6 and by a top half-shell 7, which are cup-shaped; the latter, which are preferably made of steel, are normally coupled on top of one another (Figure 1) with their concavities facing one another and respective edges 8, 9 provided with appropriate gaskets (not illustrated) butted together in a fluid-tight way.

The device 1 further comprises means 10 for moving away the top half-shell 7 vertically from the bottom half-shell 6, in the case in point so that the casing 5 will assume an "open" configuration for enabling access to the graphite container 4.

The device 1 further comprises, according to one aspect of the invention: at least one top induction coil 12, in the non-limiting example illustrated with plane development, comprising turns 13, shaped, for example, according to a plane spiral, the induction coil being set, with interposition of a graphite plate 14 operatively associated thereto, facing a mouth of the graphite container 4; at least one lateral induction coil 16, set, in use, in the form of half-shells 6, 7 coupled around a side wall 17 of the graphite container 4; and a bottom induction coil 18, set facing a bottom wall 19 of the graphite container 4.

The device 1 further comprises: a.c. electrical-supply means 20, which are known and are consequently represented schematically by blocks, for supplying the induction coils 12, 16 and 18 separately and independently of one another; and cooling means 21, which are also known and are consequently represented schematically by blocks, for supplying a coolant within the turns 13, which are hollow in so far as they are constituted by tubular elements, of the induction coils 12, 16 and 18.

According to one aspect of the invention, the bottom induction coil 18 is vertically mobile so as to be able to vary in use its distance D (Figure 3) from the bottom wall 19, via movement means 30, whilst the lateral induction coil 16 (Figures 5 and 6) includes a plurality of plane turns 13, i.e., each having a development in one and the same plane of lie, which are set coaxial with respect to an axis A of symmetry of the half-shells 6, 7, and are set on top of one another in the vertical direction.

According to a known technique, the side wall 17 and bottom wall 19 of the graphite container 4 and the graphite plate 14 have a composition and dimensions such as to constitute electromagnetic susceptors for the lateral induction coil 16, the bottom induction coil 18, and the top induction coil 12, respectively.

The cooling means 21 can be obtained so that the coolant used by them that circulates in the hollow turns 13 is a diathermic oil, instead of water. In this way, in the case of any leakage of coolant within the casing 5, during the process of melting or of directional solidification, or in the event of failure of the crucible 3 with consequent spilling of the molten silicon 2 in the bottom half-shell 6, there is no risk of explosions consequent upon the possible chemical reactions of silicon with water.

According to the main aspect of the invention, the bottom induction coil 18 (Figure 2) comprises a plurality of windings 31, 32, 33 and 34, in the embodiment shown having plane development, arranged alongside one another in one and the same plane of lie defined by an insulated supporting plate 35, in turn carried by a stem or hub 36 that is moved within the half-shell 6 by the movement means 30 to vary the distance D in use.

Furthermore, according to the invention, electrical switching means 40, represented schematically with a block and not described in detail in so far as they are obvious for a person skilled in the art once their function has been identified and described, are prearranged between the windings 31-34 of the bottom induction coil 18 and the respective a.c. electrical-supply means 20 for connecting the windings 31-34 selectively to one another and to the means 20 according to different configurations, which differ from one another as regards the direction of circulation of the electric currents in the respective windings 31-34 set alongside one another, as represented schematically, for example, in Figure 3.

According to the preferred embodiment, the bottom induction coil 18 includes four windings, designated precisely by 31, 32, 33, 34, arranged alongside one another in twos, according to a chequered scheme.

The windings 31-34 are in particular shaped each as a plane spiral (Figure 2) obtained by bending a number of times on itself a copper tube to form the hollow turns 13 and subdivide the bottom induction coil 18 into respective adjacent sectors, represented schematically in Figure 4, in which the windings 31-34 are also represented schematically by circular arrows having direction concordant with that of circulation of the electric currents therein, in which sectors respective lines of flux L of the magnetic field generated by the induction coil 18 have a similar pattern.

The switching means 40 are then such as to be designed to determine selectively between adjacent sectors a pattern of the lines of flux L that is, respectively, tangential (for example Figure 4a), or normal (Figure 4c) to the boundary lines K between one sector and the next, or, again, mixed (Figure 4b).

As has been said, the cooling means 21 of at least the bottom induction coil 18 are designed to supply in the hollow turns 13 thereof a diathermic oil or else water, through the hub or stem 36, by means of respective pipe unions 50, for example, one in number for each winding 31-34; in particular, each winding 31-34 starts and terminates with a mouth 60 (Figure 2), connected via hydraulic lines 61 inside the hub or stem 36 with the pipe unions 50, which are in turn connected in a known way with the cooling means 21 .

Possibly, there may be provided between the windings 31-34 and the cooling means 21 hydraulic-switching means 70 (Figure 1) for supplying, if needed, different flows of coolant in the turns 13 of the various windings 31-34.

On the basis of what has been described it is clear that, by means of the device 1 it is possible to implement effectively a method for carrying out control of the temperature of the semiconductor material 2 in a process for directional solidification of said material, in which the latter is melted and is subsequently subjected to controlled solidification and in which the melting step is performed by heating the semiconductor material contained in the crucible 3 by means of graphite susceptors 14, 17, 19, each operatively associated to at least one respective induction coil, 12, 16, and 18, respectively, and arranged so as to surround the crucible 3.

In particular, the method for controlling the temperature of the silicon 2 in the crucible 3 comprises the steps of:
- setting under the crucible 3 a susceptor 19, in the case in point constituted by the base plate defining the bottom wall of the container 4, operatively associated to a bottom induction coil 18, comprising a plurality of windings 31-34 having a plane development and arranged alongside one another in one and the same plane of lie; and
- selectively connecting the windings 31-34 to one another and to the respective a.c. electrical-supply means 20 for supply of the bottom induction coil 18 according to different configurations, illustrated schematically in Figure 3, which differ from one another as regards the direction of circulation of the electric current, represented schematically by the direction of the circular arrows, in the respective windings 31-34, set alongside one another, which are also represented schematically by the circular arrows in Figure 3.

In particular, the windings 31-34 of the bottom induction coil 18 are connected to one another so that each winding 31-34 defines a sector of the induction coil 18 in which respective lines of flux L of the magnetic field have a similar pattern, and so that, in combination, the lines of flux L of adjacent sectors have a pattern respectively always tangential (Figure 3a) or normal (Figure 3c) to the boundary line K between one sector and the next.

Furthermore, the distance D between the bottom induction coil 18 and the respective graphite susceptor 19 associated thereto is varied according to the method of the invention, according to the need and, in particular, during the step of directional solidification, which is performed by interrupting the electrical supply of the bottom induction coil 18, keeping, however, in circulation a coolant in the hollow turns 13 thereof, and approaching the induction coil 18 to the susceptor 19 associated thereto until it is brought substantially into contact therewith, using as coolant a diathermic oil or else water, as already mentioned.

For this purpose, the induction coil 18 is set within a compartment defined by respective thermally insulating elements 100 that surround the susceptors 14, 17, 19, whereas the induction coils 12 and 16 are preferably arranged on the outside of said compartment and, hence, with the insulating elements 100 set between them and the susceptors 14, 17 associated thereto.

In this way, it has been experimentally found, as highlighted in Figure 4, that it is possible to vary with extreme simplicity and in a way that can be implemented a number of times during one and the same process the heat that the bottom graphite susceptor 19 supplies to the crucible 3. Figure 4a shows in particular the pattern of the temperatures (the areas with higher temperature are the lighter areas, according to the greyscale used in the graph of Figure 4) in the susceptor 19 when the configuration of the electric currents in the windings 31-34 is that of Figure 3a. Figures 4b and 4c show likewise the appearance of the distribution of the temperatures in the susceptor 19 when the configuration of the electric currents is that of Figure 4b and Figure 4c, respectively.

Furthermore, also the control of the temperature of the silicon 2 during solidification is markedly facilitated by the particular constructional configuration of the induction coil 18 and by its use as heat exchanger, once the latter has been deactivated by detaching its own a.c. electrical-supply means 20.

## Claims

1. A device (1) for melting and subsequent directional solidification of a semiconductor material (2), typically to obtain multicrystalline silicon with "solar" degree of purity, comprising at least one crucible (3) for the semiconductor material, preferably made of quartz or ceramic material, removably housed in a cup-shaped graphite container (4); at least one top induction coil (12), set, with at least interposition of a graphite plate (14) operatively associated thereto, facing to a mouth (15) of the graphite container; at least one lateral induction coil (16), set around a side wall (17) of the graphite container; at least one bottom induction coil (18), set facing a bottom wall (19) of the graphite container; a.c. electrical-supply means (20) for supplying said induction coils (12, 16, 18) separately and independently of one another; and cooling means (21) for supplying a coolant within respective hollow turns (13) of the induction coils; said device being **characterized in that**, in combination:
- the at least one bottom induction coil (18) comprises a plurality of windings (31-34), arranged alongside one another in one and the same plane of lie defined by an insulated supporting plate (35);
- electrical switching means (40), prearranged between the windings (31-34) of said at least one bottom induction coil (18) and the respective a.c. electrical-supply means (40) for selectively connecting the latter and the windings (31-34) to one another according to different configurations.

2. The device according to Claim 1, **characterized in that** said different configurations differ from one another as regards the direction of circulation of the electric currents in the respective windings (31-34) set alongside one another.

3. The device according to Claim 1 or Claim 2, **characterized in that** said at least one bottom induction coil (18) includes four of said windings (31-34), arranged alongside one another in twos, according to a chequered scheme.

4. The device according to any one of the preceding claims, **characterized in that** said windings (31-34) arranged alongside one another have a plane development being shaped each as a plane spiral.

5. The device according to any one of the preceding claims, **characterized in that** said windings (31-34) divide the at least one bottom induction coil (18) into respective adjacent sectors in which respective lines of flux (L) of the magnetic field generated by the induction coil (18) have a similar pattern; said switching means (40) being designed to determine selectively between adjacent sectors a pattern of the lines of flux (L) respectively tangential or normal to the boundary line (K) between one sector and the next.

6. The device according to any one of the preceding claims, **characterized in that** said at least one bottom induction coil (18) is vertically mobile so as to be able to vary in use its distance (D) from the bottom wall (19) of the graphite container (4).

7. The device according to any one of the preceding claims, **characterized in that** said cooling means (21) of the at least the bottom induction coil (18) are designed to supply a diathermic oil in the hollow turns (13) thereof.

8. The device according to any one of the preceding claims, **characterized in that** it further comprises, an openable fluid-tight casing (5) housing inside it the graphite container (4) and said induction coils (12, 16, 18).

9. A method for performing the control of the temperature in a process for directional solidification of a semiconductor material (2), wherein the semiconductor material is melted and is subsequently subjected to controlled solidification, said melting step being performed by heating the semiconductor material contained in a crucible (3) by means of graphite susceptors (14, 17, 19), each operatively associated to at least one respective induction coil (12, 16, 18) and arranged so as to surround the crucible, said method being **characterized in that** it comprises the steps of:
- setting under the crucible (3) one said susceptor (19) operatively associated to at least one bottom induction coil (18) comprising a plurality of windings (31-34) arranged alongside one another in one and the same plane of lie; and
- selectively connecting the windings (31-34) to one another and to respective a.c. electrical-supply means (40) for supply of the bottom induction coil according to different configurations that differ from one another as regards the direction of circulation of the electric currents in the respective windings (31-34) set alongside one another.

10. The method according to Claim 9, **characterized in that** said windings (31-34) of the at least one bottom induction coil (18) are connected to one another so that each winding defines a sector of the induction coil in which respective lines (L) of flux of the magnetic field have a similar pattern; and so that, in combination, the lines of flux (L) of adjacent sectors have a pattern that is respectively tangential or normal to the boundary line (K) between one sector and the next.

11. The method according to Claim 9 or Claim 10, **characterized in that** the distance (D) between said at least one bottom induction coil (18) and the respective graphite susceptor (19) associated thereto is varied.

12. The method according to any one of Claims 9 to 11, **characterized in that** the step of controlled solidification is performed by interrupting the electrical supply of the at least one bottom induction coil (18), keeping in circulation a coolant in respective hollow turns (13) thereof, and approaching the induction coil (18) to the susceptor (19) associated thereto until it is brought substantially into contact therewith.

13. The method according to Claim 12, **characterized in that** a diathermic oil is used as coolant.

## Patentansprüche

1. Vorrichtung (1) zum Schmelzen und anschließender richtungsabhängiger Verfestigung eines Halbleitermaterials (2), um typischerweise polykristallines Silizium mit einem "Solar"-Reinheitsgrad zu gewinnen, die aufweist: wenigstens einen Schmelztiegel (3) für das Halbleitermaterial, der vorzugsweise aus Quarz oder keramischem Material besteht, der entfernbar in einem becherförmigen Graphitbehälter (4) untergebracht ist; wenigstens eine obere Induktionsspule (12), die wenigstens unter Einfügung einer Graphitplatte (14) eingerichtet ist, die betriebsfähig damit verbunden ist und einer Mündung (15) des Graphitbehälters zugewandt ist; wenigstens eine seitliche Induktionsspule (16), die um eine Seitenwand (17) des Graphitbehälters herum eingerichtet ist; wenigstens eine untere Induktionsspule (18), die einer Bodenwand (19) des Graphitbehälters zugewandt eingerichtet ist; elektrische Wechselstromversorgungseinrichtungen (20) zum getrennten Versorgen der Induktionsspulen (12, 16, 18) unabhängig voneinander; und Kühleinrichtungen (21) zum Zuführen eines Kühlmittels innerhalb jeweiliger hohler Windungen (13) der Induktionsspulen; wobei die Vorrichtung **dadurch gekennzeichnet ist, dass** in Kombination:
- die wenigstens eine untere Induktionsspule (18) mehrere Wicklungen (31 - 34) aufweist, die längs aneinander in ein und derselben Lagenebene angeordnet sind, die durch eine isolierte Halteplatte (35) definiert wird;
- elektrische Schalteinrichtungen (40), die vorab zwischen den Wicklungen (31 - 34) der wenigstens einen unteren Induktionsspule (18) und den jeweiligen elektrischen Wechselstromversorgungseinrichtungen (40) angeordnet sind, um die letzteren und die Wicklungen (31 - 34) gemäß verschiedenen Konfigurationen selektiv miteinander zu verbinden.

2. Vorrichtung nach Anspruch 1, **dadurch gekennzeichnet, dass** die verschiedenen Konfigurationen sich, was die Zirkulationsrichtung elektrischer Ströme in den jeweiligen Wicklungen (31 - 34), die längs aneinander eingerichtet sind, voneinander unterscheiden.

3. Vorrichtung nach Anspruch 1 oder Anspruch 2, **dadurch gekennzeichnet, dass** wenigstens eine untere Induktionsspule (18) vier der Wicklungen (31 - 34) umfasst, die nach einem schachbrettartigen Schema paarweise längs aneinander angeordnet sind.

4. Vorrichtung nach einem der vorhergehenden Ansprüche, **dadurch gekennzeichnet, dass** die längs aneinander angeordneten Wicklungen (31 - 34) eine Ebenenentwicklung haben, die jeweils als eine Ebenenspirale geformt ist.

5. Vorrichtung nach einem der vorhergehenden Ansprüche, **dadurch gekennzeichnet, dass** die Wicklungen (31 - 34) die wenigstens eine untere Induktionsspule (18) in jeweilige benachbarte Sektoren unterteilen, in denen jeweilige Flusslinien (L) des von der Induktionsspule erzeugten Magnetfelds ein ähnliches Muster haben; dass die Schalteinrichtungen (40) derart konstruiert sind, dass sie selektiv zwischen benachbarten Sektoren eines Musters der Flusslinien (L) jeweils tangential oder normal zu der Grenzlinie (K) zwischen einem Sektor und dem nächsten entscheiden.

6. Vorrichtung nach einem der vorhergehenden Ansprüche, **dadurch gekennzeichnet, dass** wenigstens eine untere Induktionsspule (18) vertikal mobil ist, so dass sie fähig ist, ihren Abstand (D) von der Bodenwand (19) des Graphitbehälters (4) zu verändern.

7. Vorrichtung nach einem der vorhergehenden Ansprüche, **dadurch gekennzeichnet, dass** die Kühleinrichtungen (21) wenigstens der unteren Induktionsspule (18) konstruiert sind, um ein diathermisches Öl in ihren hohlen Windungen (13) zuzuführen.

8. Vorrichtung nach einem der vorhergehenden Ansprüche, **dadurch gekennzeichnet, dass** sie ferner ein zu öffnendes fluiddichtes Gehäuse (5) aufweist, das in seinem Inneren den Graphitbehälter (4) und die Induktionsspulen (12, 16, 18) aufweist.

9. Verfahren zum Durchführen der Steuerung der Temperatur in einem Verfahren zur richtungsabhängigen Verfestigung eines Halbleitermaterials, wobei das Halbleitermaterial geschmolzen wird und anschließend einer gesteuerten Verfestigung unterzogen wird, wobei der Schmelzschritt durchgeführt wird, indem das in einem Schmelztiegel (3) enthaltene Halbleitermaterial mit Hilfe von Graphitsuszeptoren (14, 17, 19) geheizt wird, von denen jeder betriebsfähig mit wenigstens einer jeweiligen Induktionsspule (12, 16, 18) verbunden ist und angeordnet ist, um den Schmelztiegel zu umgeben, wobei das Verfahren **dadurch gekennzeichnet ist, dass** es die folgenden Schritte aufweist:
- Einrichten eines Suszeptors (19), der betriebsfähig mit wenigstens einer unteren Induktionsspule (18), die mehrere längs aneinander in ein und derselben Lagenebene angeordnete Wicklungen (31 - 34) aufweist, verbunden ist, unter dem Schmelztiegel (3); und
- selektives Verbinden der Wicklungen (31 - 34) miteinander und mit jeweiligen elektrischen Wechselstromversorgungseinrichtungen (40) für die Versorgung der unteren Induktionsspule gemäß verschiedenen Konfigurationen, die sich in Bezug auf die Zirkulationsrichtung der elektrischen Ströme in den jeweiligen längs aneinander festgelegten Wicklungen (31 - 34) voneinander unterscheiden.

10. Verfahren nach Anspruch 9, **dadurch gekennzeichnet, dass** die Wicklungen (31 - 34) der wenigstens einen unteren Induktionsspule (18) miteinander verbunden sind, so dass jede Wicklung einen Sektor der Induktionsspule definiert, in dem jeweiligen Flusslinien (L) des Magnetfelds ein ähnliches Muster haben; und so dass die Flusslinien (L) benachbarter Sektoren in Kombination ein Muster haben, das jeweils tangential oder normal zu der Grenzlinie (K) zwischen einem Sektor und dem nächsten ist.

11. Verfahren nach Anspruch 9 oder Anspruch 10, **dadurch gekennzeichnet, dass** der Abstand (D) zwischen der wenigstens einen unteren Induktionsspule (18) und dem jeweiligen zugeordneten Graphitsuszeptor (19) verändert wird.

12. Verfahren nach einem der Ansprüche 9 bis 11, **dadurch gekennzeichnet, dass** der Schritt der gesteuerten Verfestigung durchgeführt wird, indem er die elektrische Versorgung der wenigstens einen unteren Induktionsspule (18) unterbricht, wobei ein Kühlmittel in ihren jeweiligen hohlen Windungen (13) zirkulierend gehalten wird und die Induktionsspule (18) dem ihr zugeordneten Suszeptor (19) genähert wird, bis sie im Wesentlichen in Kontakt damit gebracht wird.

13. Verfahren nach Anspruch 12, **dadurch gekennzeichnet, dass** ein diathermisches Öl als Kühlmittel verwendet wird.

## Revendications

1. Dispositif (1) pour la fusion puis la solidification directionnelle d'un matériau semi-conducteur (2), typiquement pour obtenir du silicium polycristalline ayant un degré de pureté de qualité 'solaire', le dispositif comprenant au moins un creuset (3) destiné au matériau semi-conducteur, fabriqué de préférence à partir de quartz ou d'une matière céramique, logé de façon amovible dans un récipient (4) en graphique en forme de cuvette ; au moins une bobine d'induction supérieure (12) placée, au moins en interposant une plaque (14) en graphite fonctionnellement associée à celle-ci, en face d'une embouchure (15) du récipient en graphite ; au moins une bobine d'induction latérale (16), placée autour d'une paroi latérale (17) du récipient en graphite ; au moins une bobine d'induction inférieure (18), placée en face d'une paroi inférieure (19) du récipient graphique ; des moyens d'alimentation électrique à courant alternatif (20) pour alimenter lesdites bobines d'induction (12, 16, 18) séparément et indépendamment l'une de l'autre ; des moyens de refroidissement (21) pour alimenter en réfrigérant l'intérieur des spires creuses respectives (13) des bobines d'induction ; le dispositif étant **caractérisé en ce que**, en combinaison :
- l'au moins une bobine d'induction inférieure (18) comprend une pluralité d'enroulements (31-34), disposés à côté l'une de l'autre dans un et même plan défini par une plaque de support isolé (35) ;
- des moyens de commutation électriques (40), préalablement disposés entre les enroulements (31-34) de ladite au moins une bobine d'induction inférieure (18) et les moyens respectifs d'alimentation électrique à courant alternatif (40) pour raccorder sélectivement ceux-ci et les enroulements (31-34) l'un à l'autre dans différentes configurations.

2. Dispositif selon la revendication 1, **caractérisé en ce que** lesdites différentes configurations diffèrent l'une de l'autre par la direction de circulation des courants électriques dans les enroulements respectifs (31-34) placés l'un à côté de l'autre.

3. Dispositif selon la revendication ou la revendication 2, **caractérisé en ce que** ladite au moins une bobine d'induction inférieure (18) inclut quatre desdits enroulements (31-34), disposés deux à deux l'un à côté de l'autre, conformément à un arrangement quadrillé.

4. Dispositif selon l'une quelconque des revendications précédentes, **caractérisé en ce que** lesdits enroulements (31-34) disposés l'un à côté de l'autre présentent chacun un développement plan en forme de spirale plane.

5. Dispositif selon l'une quelconque des revendications précédentes, **caractérisé en ce que** lesdits enroulements (31-34) divisent l'au moins une bobine d'induction inférieure (18) en secteurs adjacents respectifs dans lesquels des lignes respectives de flux (L) du champ magnétique généré par la bobine induction (18) présentent un motif similaire ; lesdits moyens de commutation (40) étant conçus pour déterminer sélectivement entre des secteurs adjacents un motif de lignes de flux (L) respectivement tangentiel ou normal à la ligne frontière (K) entre un secteur et le suivant.

6. Dispositif selon l'une quelconque des revendications précédentes, **caractérisé en ce que** ladite au moins une bobine d'induction inférieure (18) est mobile verticalement de manière à pouvoir faire varier en utilisation la distance (D) de celle-ci à la paroi inférieure (19) du récipient (4) en graphite.

7. Dispositif selon l'une quelconque des revendications précédentes, **caractérisé en ce que** lesdits moyens de refroidissement (21) d'au moins la bobine d'induction inférieure (18) sont conçus pour alimenter l'intérieur des spires creuses (13) de celle-ci en huile diathermique.

8. Dispositif selon l'une quelconque des revendications précédentes, **caractérisé en ce qu'**il comprend en outre un boîtier (5) ouvrable et étanche aux fluides et dans lequel sont logés le récipient (4) en graphite et lesdites bobines d'induction (12, 16, 18).

9. Procédé effectuant le contrôle de la température dans un processus de solidification directionnelle d'un matériau semi-conducteur (2), dans lequel le matériau semi-conducteur est fondu puis soumis à une solidification contrôlée et dans lequel l'on réalise ladite étape de fusion en chauffant le matériau semi-conducteur contenu dans un creuset (3) au moyen de suscepteurs (14, 17, 19) en graphite, chacun d'eux étant fonctionnellement associés à au moins une bobine d'induction respective (12, 16, 18) et disposés de manière à entourer le creuset, ledit procédé étant **caractérisé en ce qu'**il comprend les étapes consistant à :
- placer sous le creuset (3) un suscepteur (19) fonctionnellement associé à au moins une bobine induction inférieure (18) comprenant une pluralité d'enroulements (31-34) disposés l'un à côté de l'autre dans un et même plan ; et
- raccorder sélectivement les enroulements (31-34) l'un à l'autre et à des moyens respectifs d'alimentation électrique à courant alternatif (40) pour alimenter la bobine d'induction inférieure dans différentes configurations qui diffèrent l'une de l'autre par la direction de circulation des courants électriques dans les enroulements respectifs (31-34) placés l'un à côté de l'autre.

10. Procédé selon la revendication 9, **caractérisé en ce que** lesdits enroulements (31-34) de l'au moins une bobine d'induction inférieure (18) sont raccordées l'un à l'autre de telle sorte que chaque enroulement définit un secteur de la bobine d'induction dans lequel des lignes de flux respectives (L) du champ magnétique présentent un motif similaire ; et de telle sorte que, en combinaison, les lignes de flux (L) de secteurs adjacents présentent un motif qui est respectivement tangentiel ou normal à la ligne frontière (K) entre un secteur et le suivant.

11. Procédé selon la revendication 9 ou la revendication 10, **caractérisé en ce que** l'on fait varier la distance (D) entre ladite au moins une bobine d'induction inférieure (18) et le suscepteur respectif (19) en graphite associé à celle-ci.

12. Procédé selon l'une quelconque des revendications 9 à 11, **caractérisé en ce que** l'on réalise l'étape de solidification commandée en interrompant l'alimentation électrique de l'au moins une bobine d'induction inférieure (18), en maintenant en circulation un réfrigérant à l'intérieur de spires creuses respectives (13) de celle-ci, et en rapprochant la bobine d'induction (18) du suscepteur (19) associé à celle-ci jusqu'à ce qu'elle vienne sensiblement en contact avec lui.

13. Procédé selon la revendication 12, **caractérisé en ce que** l'on utilise comme réfrigérant une huile diathermique.
